Europäisches Patentamt

European Patent Office

Office européen des brevets

(19)

(11) **EP 0 905 710 B1**

(12) **EUROPEAN PATENT SPECIFICATION**

(45) Date of publication and mention
of the grant of the patent:
**23.07.2003 Bulletin 2003/30**

(51) Int Cl.$^7$: **G11C 16/06**, G11C 5/14,
G05F 3/26

(21) Application number: **97830484.8**

(22) Date of filing: **30.09.1997**

(54) **Voltage regulator with voltage drop compensation for a programming circuitry of non-volatile electrically programmable memory cells**

Spannungsregler mit Spannungsabfallkompensation für Programmierschaltung von nichtflüchtigen und elektrisch programmierbaren Speicherzellen

Régulateur de tension avec compensation de chute de tension pour circuit de programmation de cellules de mémoire non volatiles électriquement programmables

(84) Designated Contracting States:
**DE FR GB IT**

(43) Date of publication of application:
**31.03.1999 Bulletin 1999/13**

(73) Proprietor: **STMicroelectronics S.r.l.**
**20041 Agrate Brianza (Milano) (IT)**

(72) Inventors:
• **Fontana, Marco**
**20100 Milano (IT)**

• **Montanaro, Massimo**
**27100 Pavia (IT)**

(74) Representative: **Botti, Mario**
**Botti & Ferrari S.r.l.,**
**Via Locatelli, 5**
**20124 Milano (IT)**

(56) References cited:
**EP-A- 0 661 717**      **WO-A-93/16427**
**US-A- 5 212 458**

# Description

## Field of the Invention

This invention relates to a voltage regulator for suitably biasing the terminals of electrically programmable non-volatile memory cells.

In particular, the invention relates to a compensated voltage regulator useful with programming circuitry for electrically programmable non-volatile memory cells in a cell matrix which is divided in sectors, said regulator being of a type which includes a comparator connected between first and second supply voltage references, and having:

a first input terminal which is supplied by a reference voltage;

an output terminal connected to the control terminal of an output MOS transistor having a conduction terminal through which an output current is passed and being connected to the memory cells by a program line;

a second input terminal, feedback connected to said program line.

As is well known, electrically programmable non-volatile memories are constructed as matrices of memory cells, each comprised of a floating-gate MOS transistor with respective drain and source regions.

The floating gate is formed over the semiconductor substrate and is isolated from the latter by a thin layer of gate oxide. A control gate is coupled capacitively through a dielectric layer to the floating gate. Metal electrodes are provided for contacting the drain, source, and control gate in order for predetermined value voltages to be applied to the memory cell.

By suitably biasing the cell terminals, the amount of charge present on the floating gate can be varied. The operation whereby charge is stored up in the floating gate is called "programming", and consists of biasing the drain terminal and the control gate to a predetermined higher value than the potential at the source terminal.

A semiconductor-integrated memory device usually includes a very large number of cells of the above-mentioned type. The cells are organized in a matrix formed of rows, or word lines, and columns, or bit lines. All the cells in one word line share a electric drive line for their respective control gates, while the cells in one bit line have their drain terminals in common.

The programming or writing of an individual memory cell is based on the well-known phenomenon of hot electron injection. In essence, the cell programming is enabled by an injection of hot electrons into its floating gate.

Such hot electrons are generated in the channel of the floating-gate transistor, in the proximities of the drain region and in the presence of electric fields of such strength that the electrons are conferred a much different mobility from that due to their normal thermal agitation.

For the injection of electrons to take place, the electrons must be supplied kinetic energy of a greater magnitude than the potential energy existing between the channel and the gate region. This is achieved by biasing the gate and drain terminals of the memory cell at relatively high voltages, e.g. of 12.5V and 6.5V, respectively.

This biasing step involves considerable dissipation of current, and it is vital that the cell accessing resistors should produce no such voltage drops as may degrade the value of the bias voltage applied.

It is indeed well recognized that, for cells of the flash type, a reduced value of the drain voltage Vpd produces an insufficient or slow-rate cell programming.

On the other hand, too high a value of the drain voltage Vpd may give rise to destructive snap-back phenomena, or cause the cell to be soft-erased, i.e. become partially erased.

The optimum range for the drain voltage Vpd is, therefore, a fairly limited one, with variations on the order of 200mV to 300mV from a typical reference value dictated by the technology. The writing rate and snap-back phenomenon respectively set the lower and upper end points of the drain voltage variation range which is acceptable for correct programming of the cell.

Memory devices are provided with a sophisticated type of voltage regulator adapted to supply the bit lines of the cell matrix with an accurately regulated drain voltage during their programming step.

However, advanced miniaturizing technologies make it increasingly more difficult to provide programming circuitry which is capable of generating appropriate bias voltages. In fact, the reduced width and thickness of the interconnect lines result in higher reasistance of the conduction paths used for applying the drain voltage to the memory cells. In addition, the current dissipation of each cell increases as a result of the reduced oxide thicknesses.

These problems become even more acute at the testing stage, when a plurality of cell are to be programmed in parallel and simultaneously in order to lower the cost and time for the operation. This results, in fact, in increased voltage drops across the conduction paths used for accessing the drain terminals of the cells.

Furthermore, the reduced channel length brought about by the ongoing miniaturization processes significantly restricts the variation range of the drain voltage, mainly on account of the lower snap-back voltage.

## Background Art

A number of programming circuits are proposed by the state of the art to solve these problems.

For example, a typical solution is described in European Patent Application No. 93830545.5, (= EP-A-0 661 717) wherein a drain voltage regulator has slightly higher output voltage than the desired voltage on the bit line.

The voltage difference is istantaneously dependent on the current actually flowing through the bit line select transistors.

A regulator of this type is formed by means of an adaptive bias technique using a positive feedback structure. This structure provides for the use of a "central" generator including an average voltage drop compensator for the access lines to the cell drains.

The voltage is regulated by means of a feedback circuit of the cascode-compensator type. In this case, however, an outer feedback loop also exists which modifies the system reference voltage according to the output current. Thus, the generator will supply a higher output voltage with larger output currents. This allows compensation of the voltage drop across the cell access lines. However, the bias variation due to the number of cells being programmed and their locations remains quite high.

While being advantageous in several ways, this prior solution applies its control action to the whole of the cells, and disallows a high programming parallelism effective to speed up the memory device testing procedure.

A more recent prior solution is described in another European Patent Application, No. 96830192.9 (EP-A-0 800 176), wherein local drain voltage generators are employed for each output sector of the memory matrix.

Figure 1 shows schematically an example of programming circuitry incorporating local generators of a drain voltage Vpd.

Figure 2 shows a more detailed electric diagram of the programming circuitry of Figure 1.

Vpp line represents the high-voltage supply for the programming step (Vpp=12.5V, for example).

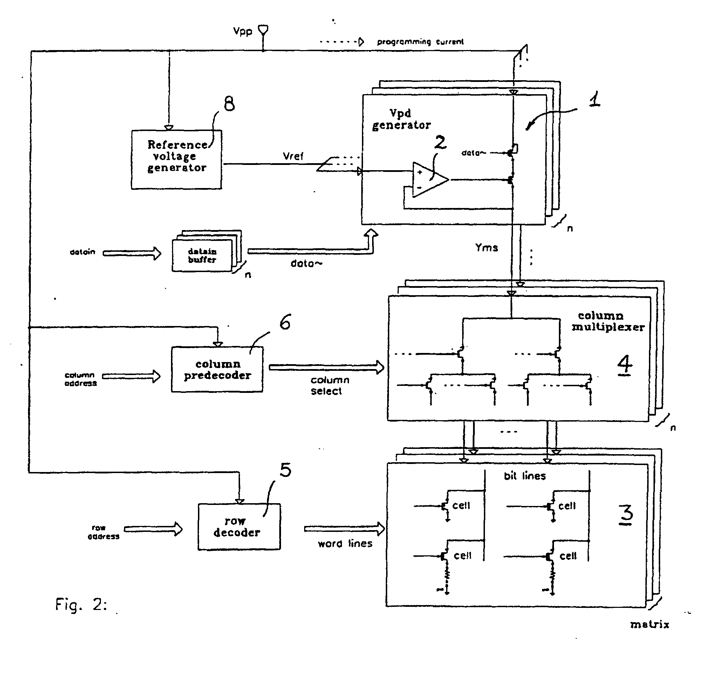

In the circuitry shown in Figure 2, a reference voltage Vref is generated, usually as a division of the program voltage Vpp. This reference voltage Vref generally has a value of 6.5V which is "duplicated", with low output resistance, by the drain voltage Vpd generators. These generators locate adjacent to the memory matrix so that the access path to the cell drains is much shorter than in arrangements having a "central" generator and providing long signal distribution paths and transistors for accessing the matrix sectors which contain cells to be programmed.

In this second solution, moreover, the cell biasing is unaffected by how many and which output sectors happen to be involved in the programming. This also holds true for parallel programming, since it is possible to activate several independent paths at the output of each generator by acting on column selection.

The circuit structure provided by this second solution comprises a negative feedback regulator which can smooth out the output voltage (Vyms) to a value close to the reference voltage (Vref) even at large output currents. The high differential gain of the comparator, the ample dynamic range of its output signal, and the high transconductance of the cascodes ensure regulation even in situations of considerable drift of the technological parameters and degradation of the supply voltage Vpp.

A capacitor at the comparator output is effective to create a dominant time constant in the feedback network which prevents overshooting at both the transient and the regulation phases.

Also provided are enable transistors controlled by a program signal, which inhibit the generator action when the data to be written into the cell correspond to the state of a virgin cell.

Even this second solution may be unsatisfactory where the resistance downstream of the generators becomes too high. For example, with very long bit lines, or where the current drain of the cells is quite large, as is the case with parallel programming, a voltage drop may occur across the whole of Vpp line resulting in the reference voltages being degraded.

The underlying technical problem of this invention is to provide a voltage regulator with such structural and functional features that the drain voltage Vpd during the programing step of plural memory cells can be held constant, thereby speeding up the memory device testing procedure and overcoming the aforementioned drawbacks which beset state-of-art solutions.

Summary of the Invention

The solving idea behind this invention is to provide for a suitably attenuated duplication of the output current Iout and to use the duplicated current Iout*$\alpha$ to modify the output voltage Vg of the comparator included in the regulator.

The technical problem is solved by a voltage regulator as previously indicated and defined in the characterizing portion of Claim 1 appended hereto.

The features and advantages of a regulator according to this invention will be apparent from the following description of an embodiment thereof, given by way of non-limitative example with reference to the accompanying drawings.

Brief Description of the Drawings

In the drawings:

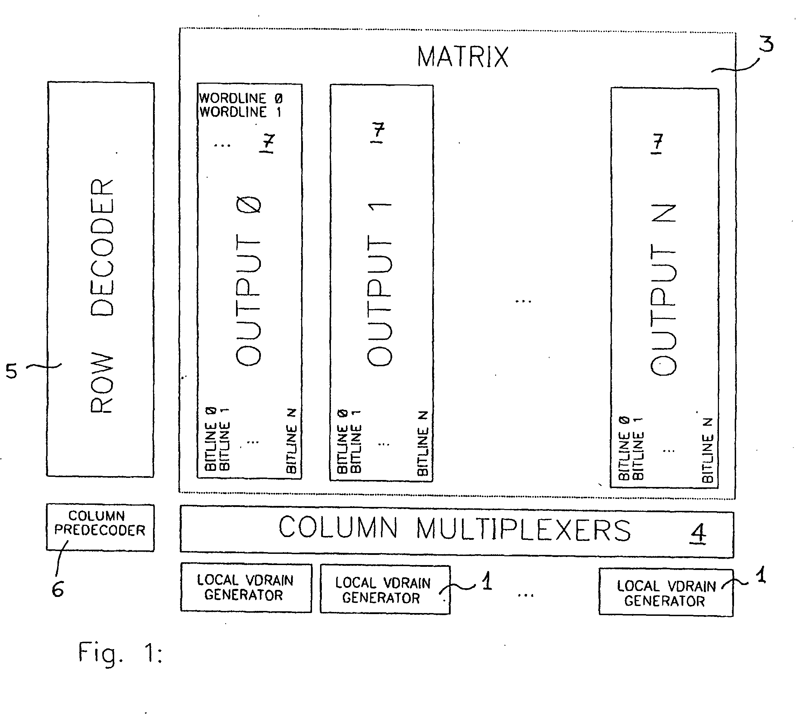

Figure 1 shows schematically a programming circuitry for an electronic memory device incorporating a plurality of local voltage regulators;

Figure 2 is a more detailed diagram of the circuitry shown in Figure 1;

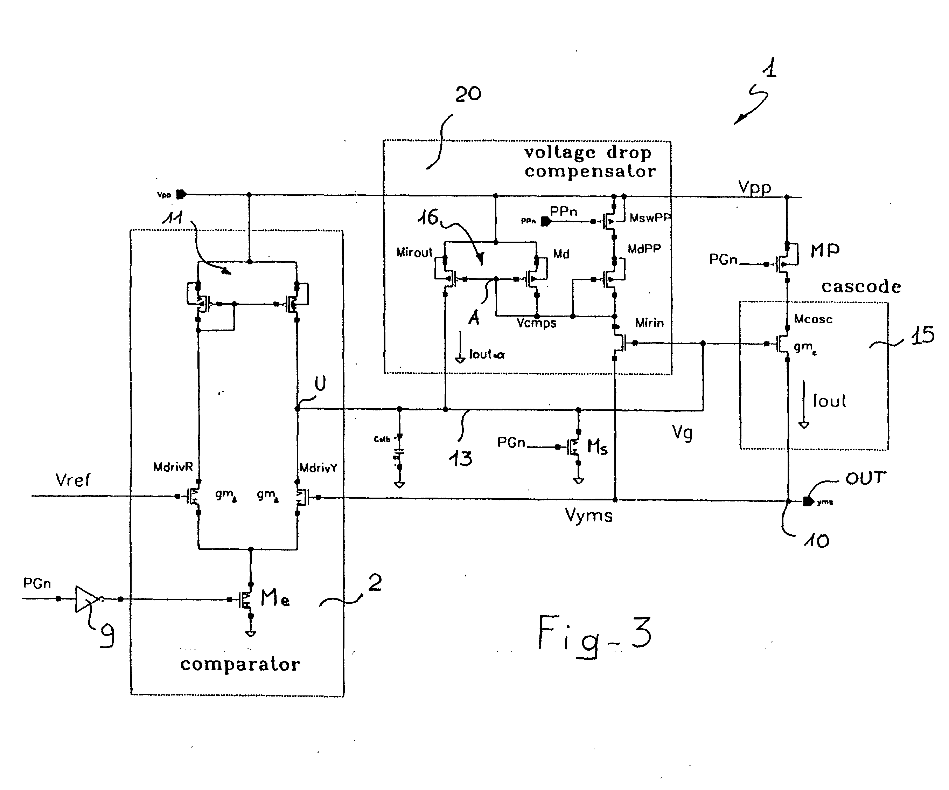

Figure 3 shows schematically an embodiment of a voltage regulator according to the invention, intended for incorporation to the circuitry of Figure 1.

Detailed Description

Referring in particular to the example of Figure 3, generally and schematically shown at 1 is a voltage regulator for suitably biasing the terminals of electrically programmable/erasable non-volatile memory cells, such as cells of the FLASH EEPROM type.

The cells are organized into a matrix 3 of the type formed of rows or word lines, and columns or bit lines. All the cells in one bit line have their respective drain terminals in common. A conventional row decoder 5 is associated with the matrix 3; also associated with the matrix 3 are a column pre-decoder 6 and its multiplexer 4.

The regulator 1 is particularly, but not exclusively, intended for a flash memory device comprising a cell matrix 3 divided into N sectors 7, e.g. sixteen sectors of at least one Mbit each and with memory words of sixteen bits.

There is one regulator 1 provided for each sector 7 of the memory matrix 3. The regulators 1 are similar constructions, and only one of them will be described hereinafter.

The invention provides for plural local regulators, each compensated for the output voltage drop.

The general construction of the programming circuitry to which the regulators 1 are incorporated is illustrated by Figures 1 and 2, which show substantially conventional circuit diagrams.

Each regulator 1 is powered between first Vpp and second GND voltage references. The first reference Vpp is a programming voltage of about 12.5V, to be applied to the word line of the cell matrix during the programming step. The second voltage reference GND is a signal ground.

The regulator 1 includes enable transistors and an operational amplifier 2 which is suitably feedback-connected to function as a comparator.

This comparator 2 has a first non-inverting input (+) which is applied a voltage reference Vref provided by a generator 8 effecting a division of the programming voltage Vpp.

Advantageously, the comparator 2 is controlled, as shown in Figure 3, by a programming step enable signal PG.

In detail, the comparator 2 comprises a pair of input MOS transistors MdrivR and MdrivY having respective source terminals connected together and connected to the ground GND through a transistor Me. The transistor Me receives a signal PG on its control terminal which is produced from the output of an inverter 9 being input a negated signal PGn.

The comparator 2 is conventionally biased by a current mirror 11 connected between the supply Vpp and the aforesaid input transistors.

The comparator 2 of the regulator 1 has an output U connected by a line 13 to an output switch 15 which comprises an NMOS transistor Mcasc being a high transconductance cascode. A signal Vg is produced at the output U which is the outcome of the regulation performed by the comparator 2, as corrected according to the invention by a compensation block 20 to be described.

A smoothing capacitor Cstb and a discharge transistor Ms are respectively and independently connected between the output U and the ground GND. The transistor Ms receives the signal PGn on its control terminal.

The transistor Mcasc is connected to the supply Vpp by a cascode connection with a PMOS transistor MP having its body terminal connected to the supply Vpp and receiving the signal PGn on its control terminal.

The transistor Mcasc is further connected to a program line 10 connected to the bit lines of the memory matrix 3.

The line 10 is also connected to the second inverting input (-) of the comparator 2 which is coincident with the control terminal of the input transistor MdrivY. In this way, a feedback loop is provided.

The feedback loop, connected to the inverting input of the comparator 2, allows the value of Vreg to be smoothed according to the current drain from the line 10.

The construction of the compensation block 20 will now be explained.

This block 20 basically comprises a current mirror and a switch which is activated during the parallel programming step.

A first NMOS transistor Mirin is included in an input leg of a current mirror 16. This first transistor Mirin has its control terminal connected to the control terminal of the transistor Mcasc in the cascode switch 15.

The source terminal of the transistor Mirin is connected to the line 10.

The drain terminal of the transistor Mirin is connected to the supply Vpp through a series of a load transistor MdPP and a controlled transistor MswPP which is responsive to a signal PPn.

Both series transistors MdPP and MswPP are of the PMOS type with their body terminal connected toward the supply.

The control terminal of the load transistor MdPP is connected to the drain terminal of the transistor Mirin and, jointly therewith, to the output leg of the current mirror 16. In particular, a circuit node A connects the control terminals together of a PMOS transistor pair comprising an output transistor Mirout of the mirror 16 and a second load transistor Md.

The node A coincides with the drain terminal of the transistor Mirin and the drain terminal of the second load transistor Md. A voltage value Vcmps is present at the node A.

The source terminals of either transistors Mirout and Md are connected to the supply Vpp, while their respective body terminals are connected to the source terminals. Accordingly, both transistors are diode configured.

The drain terminal of the output transistor Mirout of the mirror 16 is connected to the connection line 13 going to the output U of the comparator 2. This transistor produces a current which is proportional by a parameter $\alpha$ to the output current Iout of the cascode 15.

The operation of the compensator 20 is based upon a suitably attenuated duplication of the output current Iout and the use of this duplicated current Iout*$\alpha$ to modify the output voltage Vg of the comparator 2.

The compensator 20 overcompensates the output current Iout by driving the cascodes such that the output resistance will be negative.

The operation of the compensator 20 will be described next in further detail.

The transistor Mirin operates as an input current mirror. In fact, since both transistors Mirin and Mcasc have similar source and gate bias and are operated in their saturation range, the currents they dissipate will be proportional to their dimensional ratio.

This enables the cascode current Iout to be mirrored with high attenuation. The input current to the compensator 20 is then converted to a voltage Vcmps by the second load transistor in diode configuration.

In the instance of a parallel programming step being carried out, the switch MswPP would be turned on by the signal Ppn and, accordingly, the first load transistor MdPP would be connected in parallel to the second load transistor Md.

The voltage Vcmps generates a current Iout*$\propto$ through the output transistor Mirout operated in a saturated state.

Since the combination of the transistors Mirout, Md and Mdpp also form a current mirror, the outgoing current from the compensator 20 will be proportional to the cascode current Iout.

The attenuation factor has been previously indicated as the parameter $\alpha$.

The current Iout*$\alpha$ generated by the compensator 20 alters the balance of currents at the output node U of the comparator 2, and increases the voltage Vg at the node U.

The current balance is restored as the voltage Yms at the output node OUT of the regulator 1 allows the corresponding input transistor MdrivY to take back in the compensation current Iout*$\alpha$.

Assuming the differential gain of the comparator 2 to be infinite, for a given output current Iout the voltage at the node OUT Yms will be:

$$Vyms = Vref + (\alpha/gm) * Iout$$

where, gm is the transconductance of the input transistors MdrivR, MdrivY of the comparator 2.

The compensation factor is arranged, as by appropriate dimensioning of the current mirrors, to cancel out the effects of the voltage drop across an access line of "standard" type. For memory cells located at the end of such a line, the following relation applies:

$$Vdrain = Vref.$$

The value of the compensation factor can now be expressed analytically. From relation:

$$Vdrain = Vysm - Rdrop * Iout$$

with Rdrop being the resistance of the line under consideration, it is:

$$Vdrain = Vref + (\alpha/gm - Rdrop) * Iout$$

and therefore:

$$\alpha \; Rdrop * gm$$

The compensation factor $\alpha$ would be modified, as mentioned, in the instance of parallel programming.

Using n to denote the number of cells to be programmed by a single regulator 1, the corrected output current to be considered for compensation is given as Iout/n.

This current can be obtained, according to the invention, in quite an equivalent manner by reducing the compensation factor $\alpha$.

Thus, the parameter $\alpha p$ to be used with parallel programming is given as $\alpha/n$.

In the presence of very large output currents Iout or substantial drops in the voltage of Vpp, the transistors Mirin and Mirout of the mirror 16 are dimensioned, in the compensation circuitry, to exit their saturation range ahead of the transistors MdrivR and MdrivY of the comparator 2.

Thus, the performance of the regulator 1 becomes, under the above conditions, similar to that of an uncompensated regulator, thereby avoiding the instability problems which are typical of all circuits with a negative output resistance.

The voltage regulator of this invention does solve the technical problem and affords several advantages, foremost among which is an improved writing rate.

This reflects in superior efficiency during the write step and a shortened testing time. The programming parallelism made possible by the regulator of this invention is highly useful during the cell matrix testing.

The parallelism may indeed be enhanced to reduce selection time.

The regulator of this invention involves a limited increase in occupied area and constructional complexity over prior solutions.

In addition, using the regulator of this invention, the regulation is always applied locally, for each sector 7 of the matrix 3. In this way, the regulation is made independent of any voltage drops in the supply Vpp, as well as of the locations of the various circuit portions being programmed.

Modifications and variations may be made unto the regulator of this invention as the following claims may comprehend.

## Claims

1. A compensated voltage regulator (1) useful with programming circuitry for electrically programmable non-volatile memory cells in a cell matrix (3) which is divided in sectors (7), said regulator being of a type which includes a comparator (2) connected between first (Vpp) and second (GND) supply voltage references, and having:

   a first input terminal (+) which is supplied a by reference voltage (Vref);

   an output terminal (U) connected to the control terminal of an output MOS transistor (Mcasc) having a conduction terminal through which an output current (Iout) is passed and being connected to the memory cells by a program line (10);

   a second input terminal (-), feedback connected to said program line (10);

   **characterized in that** it comprises a compensation block (20) powered from said first voltage reference (Vpp) and having inputs connected to said output terminal (U) and the output of said output transistor (Mcasc) respectively, and having an output connected to said output terminal (U) to generate a current (Iout*$\alpha$) which is proportional to said output current (Iout) and attenuated with respect thereto by a predetermined $\alpha$ value, for supply to said output terminal (U).

2. A regulator according to Claim 1, **characterized in that** said compensator (20) includes a current mirror circuit (16) comprising an input transistor (Mirin) connected to said output transistor (Mcasc).

3. A regulator according to Claim 2, **characterized in that** said input transistor (Mirin) and said output transistor (Mcasc) have respective control terminals connected together and respective source terminals connected to said program line (10).

4. A regulator according to Claim 2, **characterized in that** said current mirror (16) further comprises an output transistor (Mirout) coupled to said input transistor (Mirin) through at least one load transistor (Md).

5. A regulator according to Claim 4, **characterized in that** the input (Mirin) and output (Mirout) transistors of said current mirror (16) are coupled together through at least one pair of load transistors in parallel with each other.

6. A regulator according to Claim 4, **characterized in that** the input (Mirin) and output (Mirout) transistors of said current mirror (16) are coupled together through at least one pair of load transistors which are adapted to be connected in parallel with each other by operation of a switch (MswPP) controlled by a parallel programming enable signal (Ppn).

7. A regulator according to Claim 6, **characterized in that** said switch (MswPP) is a PMOS transistor connected between a voltage supply reference (Vpp) and one of said load transistors (MdPP).

8. A regulator according to Claim 4, **characterized in that** said at least one load transistor (Md) is in a diode configuration.

9. A regulator according to Claim 1, **characterized in that** the input (Mirin) and output (Mirout) transistors of said current mirror (16) are PMOS transistors.

10. Programming circuitry for a semiconductor integrated memory device having a matrix (3) of non-volatile memory cells, **characterized in that** it includes a regulator (1) according to Claim 1 for each sector (7) of the memory cell matrix (3).

## Patentansprüche

1. Kompensierter Spannungsregler (1), der für einen Programmier-Schaltungsaufbau für elektrisch programmierbare, nicht flüchtige Speicherzellen in einer in Sektoren (7) eingeteilten Zellenmatrix (3) brauchbar ist, wobei der Regler von der Bauart ist, die einen zwischen eine erste (Vpp) und zweite (GND) Versorgungsvergleichsspannung angeschlossenen Komparator (2) aufweist, und folgendes umfasst:

   einen ersten Eingangsanschluss (+), der mit einer Vergleichsspannung (Vref) gespeist wird;

einen Ausgangsanschluss (U), der mit dem Steueranschluss eines MOS-Ausgangstransistors (Mcasc) verbunden ist, welcher einen Leitungsanschluss aufweist, durch den ein Ausgangsstrom (Iout) geleitet wird und der mit den Speicherzellen über eine Programmleitung (10) verbunden ist;

ein zweiter Eingangsanschluss (-), der mit der Programmleitung (10) über eine Rückkopplung verbunden ist;

**dadurch gekennzeichnet, dass** er einen Kompensationsblock (20) umfasst, der von der ersten Vergleichsspannung (Vpp) gespeist wird und Eingänge aufweist, die mit dem Ausgangsanschluss (U) bzw. dem Ausgang des Ausgangstransistors (Mcasc) verbunden sind, sowie einen Ausgang hat, der mit dem Ausgangsanschluss (U) verbunden ist, um einen Strom (I-out*$\alpha$) zu erzeugen, der proportional zu dem Ausgangsstrom (Iout) ist und im Hinblick auf diesen um einen vorbestimmten $\alpha$-Wert abgeschwächt ist, um den Ausgangsanschlusses (U) zu speisen.

2. Regler nach Anspruch 1, **dadurch gekennzeichnet, dass** der Kompensator (20) eine Stromspiegelschaltung (16) aufweist, die einen mit dem Ausgangstransistor (Mcasc) verbundenen Eingangstransistor (Mirin) umfasst.

3. Regler nach Anspruch 2, **dadurch gekennzeichnet, dass** der Eingangstransistor (Mirin) und der Ausgangstransistor (Mcasc) jeweilige Steueranschlüsse haben, die miteinander und mit jeweiligen, mit der Programmleitung (10) verbundenen Source-Anschlüssen verbunden sind.

4. Regler nach Anspruch 2, **dadurch gekennzeichnet, dass** der Stromspiegel (16) weiter einen Ausgangstransistor (Mirout) umfasst, der an den Eingangstransistor (Mirin) über mindestens einen Lasttransistor (Md) gekoppelt ist.

5. Regler nach Anspruch 4, **dadurch gekennzeichnet, dass** der Eingangstransistor (Mirin) und Ausgangstransistor (Mirout) des Stromspiegels (16) miteinander über mindestens ein Paar Lasttransistoren parallel zusammengeschaltet sind.

6. Regler nach Anspruch 4, **dadurch gekennzeichnet, dass** der Eingangstransistor (Mirin) und der Ausgangstransistor (Mirout) des Stromspiegels (16) über mindestens ein Paar Lasttransistoren zusammengeschaltet sind, die so angepasst sind, dass sie miteinander durch das Betätigen eines durch ein paralleles Programmierfreigabesignal (Ppn) gesteuerten Schalters (MswPP) parallel geschaltet sind.

7. Regler nach Anspruch 6, **dadurch gekennzeichnet, dass** der Schalter (MswPP) ein PMOS-Transistor ist, der zwischen eine Versorgungsvergleichsspannung (Vpp) und einen der Lasttransistoren (MdPP) geschaltet ist.

8. Regler nach Anspruch 4, **dadurch gekennzeichnet, dass** mindestens ein Lasttransistor (Md) eine Diodenkonfiguration hat.

9. Regler nach Anspruch 1, **dadurch gekennzeichnet, dass** der Eingangstransistor (Mirin) und der Ausgangstransistor (Mirout) des Stromspiegels (16) PMOS-Transistoren sind.

10. Programmier-Schaltungsaufbau für ein integriertes Halbleiter-Speicherbauelement mit einer Matrix (3) aus nicht flüchtigen Speicherzellen, **dadurch gekennzeichnet, dass** er für jeden Sektor (7) der Speicherzellenmatrix (3) einen Regler (1) gemäß Anspruch 1 aufweist.

## Revendications

1. Régulateur (1) de tension compensée utile dans les circuits de programmation pour cellules de mémoire non volatile électriquement programmables au sein d'une matrice de cellules (3) divisée en secteurs (7), ledit type de régulateur contenant un comparateur (2) connecté entre la première (Vpp) et la deuxième (GND) tension d'alimentation de référence, et comportant :

une première borne d'entrée (+) alimentée par une tension de référence (Vref) ;
une borne de sortie (U) connectée à la borne de commande d'un transistor MOS de sortie (Mcasc) ayant une borne de conduction délivrant par un courant de sortie (Iout) et connectée aux cellules de mémoire par une ligne de programmation (10) ;
une deuxième borne d'entrée (-), connectée rétroactivement à ladite ligne de programmation (10) ;

**caractérisé en ce qu'**il comprend un bloc de compensation (20) alimenté par ladite première tension de référence (Vpp) et dont les entrées sont connectées respectivement à ladite borne de sortie (U) et à la sortie dudit transistor de sortie (Mcasc), et dont une sortie est connectée à ladite borne de sortie (U) pour engendrer un courant (Iout*$\alpha$) proportionnel audit courant de sortie (Iout) et diminué par rapport à ce dernier d'une valeur $\alpha$ prédéfinie, alimentant ladite borne de sortie (U).

**2.** Régulateur selon la revendication 1, **caractérisé en ce que** ledit compensateur (20) comporte un circuit miroir de courant (16) comprenant un transistor d'entrée (Mirin) connecté audit transistor de sortie (Moasc).

**3.** Régulateur selon la revendication 2, **caractérisé en ce que** ledit transistor d'entrée (Mirin) et ledit transistor de sortie (Mcasc) ont leurs bornes de contrôle respectives connectées entre elles et leurs bornes de source respectives connectées à ladite ligne de programmation (10).

**4.** Régulateur selon la revendication 2, **caractérisé en ce que** ledit miroir de courant (16) comporte en outre un transistor de sortie (Mirout) couplé audit transistor d'entrée (Mirin) par le biais d'au moins un transistor de charge (Md).

**5.** Régulateur selon la revendication 4, **caractérisé en ce que** les transistors d'entrée (Mirin) et de sortie (Mirout) dudit miroir de courant (16) sont couplés entre eux par le biais d'au moins une paire de transistors de charge montés en parallèle l'un par rapport à l'autre.

**6.** Régulateur selon la revendication 4, **caractérisé en ce que** les transistors d'entrée (Mirin) et de sortie (Mirout) dudit miroir de courant (16) sont couplés entre eux par le biais d'au moins une paire de transistors de charge adaptés pour une connexion en parallèle par le biais d'un interrupteur (MswPP) commandé par un signal de déclenchement de programmation parallèle (Ppn).

**7.** Régulateur selon la revendication 6, **caractérisé en ce que** ledit interrupteur (MswPP) est un transistor PMOS connecté entre une référence de tension d'alimentation (Vpp) et l'un desdits transistors de charge (MdPP).

**8.** Régulateur selon la revendication 4, **caractérisé en ce qu'**au moins l'un des transistors de charge (Md) est dans une configuration de diodes.

**9.** Régulateur selon la revendication 1, **caractérisé en ce que** les transistors d'entrée (Mirin) et de sortie (Mirout) dudit miroir de courant (16) sont des transistors PMOS.

**10.** Circuit de programmation pour un dispositif de mémoire intégré semi-conducteur ayant une matrice (3) de cellules de mémoire non volatile, **caractérisé en ce qu'**il comporte un régulateur (1) selon la revendication 1 pour chaque secteur (7) de la matrice (3) de cellules de mémoire.

EP 0 905 710 B1

MATRIX 3

WORDLINE Ø
WORDLINE 1
... 7

OUTPUT Ø

BITLINE Ø
BITLINE 1
...
BITLINE N

7

OUTPUT 1

BITLINE Ø
BITLINE 1
...
BITLINE N

7

OUTPUT N

BITLINE Ø
BITLINE 1
...
BITLINE N

ROW DECODER 5

COLUMN MULTIPLEXERS 4

COLUMN PREDECODER 6

LOCAL VDRAIN GENERATOR

LOCAL VDRAIN GENERATOR 1

LOCAL VDRAIN GENERATOR 1

Fig. 1:

Fig. 2:

20

1

voltage drop
compensator

Vpp

11

PPn

MswPP

16

Mirout

Md

MdPP

Vpp

PGn

MP

cascode

A

Vcmps

Mirin

Mcosc

$gm_c$

15

Iout=α

Iout

U

Vref

MdrivR

$gm_a$   $gm_a$

MdrivY

Cstb

13

PGn

Ms

Vg

OUT

Vyms

10

PGn

9

Me

2

comparator

Fig-3